(19) Europäisches Patentamt
European Patent Office
Office européen des brevets

(11) **EP 1 692 532 B1**

(12) **EUROPÄISCHE PATENTSCHRIFT**

(45) Veröffentlichungstag und Bekanntmachung des Hinweises auf die Patenterteilung:
**15.04.2009 Patentblatt 2009/16**

(21) Anmeldenummer: **04802762.7**

(22) Anmeldetag: **19.11.2004**

(51) Int Cl.:
*G01R 31/44* (2006.01)    *H01J 9/42* (2006.01)
*H01K 3/30* (2006.01)    *G01R 31/00* (2006.01)
*H05B 37/03* (2006.01)    *H05B 37/04* (2006.01)

(86) Internationale Anmeldenummer:
**PCT/DE2004/002549**

(87) Internationale Veröffentlichungsnummer:
**WO 2005/057231 (23.06.2005 Gazette 2005/25)**

(54) **VERFAHREN ZUR FUNKTIONSPRUEFUNG EINER LAMPENSCHALTUNG**

METHOD FOR FUNCTIONAL TESTING OF A LAMP CIRCUIT

PROCEDE POUR TESTER LE FONCTIONNEMENT D'UN CIRCUIT DE LAMPE

(84) Benannte Vertragsstaaten:
**DE FR**

(30) Priorität: **11.12.2003 DE 10358383**
**25.02.2004 DE 102004009006**

(43) Veröffentlichungstag der Anmeldung:
**23.08.2006 Patentblatt 2006/34**

(73) Patentinhaber: **Conti Temic microelectronic GmbH**
**90411 Nürnberg (DE)**

(72) Erfinder:
• **JOOS, Uli**
  **88149 Nonnenhorn (DE)**
• **ZWICK, Jochen**
  **88677 Markdorf (DE)**
• **JEUTNER, Nicolai**
  **90762 Fürth (DE)**

(56) Entgegenhaltungen:
**EP-A- 0 507 186**    **GB-A- 1 125 089**
**GB-A- 2 252 685**    **GB-A- 2 341 017**
**US-A- 5 578 998**    **US-A- 5 592 051**
**US-A- 5 986 462**    **US-A1- 2001 045 833**

**Beschreibung**

Die Erfindung betrifft ein Verfahren zur Funktionsprüfung einer Lampenschaltung, bestehend aus mindestens einer Lampe, durch Messung von Strom und Spannung.

Die Nennleistung einer Lampe ist die elektrische Leistungsaufnahme der Lampe bei Vorliegen definierter Normbedingungen, insbesondere Anliegen einer Nennspannung, und wird neben der Nennspannung als Lampenparameter von Lampenherstellern angegeben und von Herstellern von Beleuchtungssystemen als einzuhaltender Normwert gefordert. Dennoch weichen Lampen teilweise recht erheblich von den angegebenen Normwerten ab, was zu Störungen oder Defekten in der Beleuchtungssteuerung oder den Lampen führen kann.

Beleuchtungssysteme werden auch in sicherheitsrelevanten Anwendungen, insbesondere auch in Kraftfahrzeugen eingesetzt. Bei derartigen sicherheitskritischen Anwendungen ist es erforderlich, diese während des Betriebs auf Defekte oder den Einbau nicht normgerechter Lampen hin zu überprüfen.

Bei der Ansteuerung vom Glühfadenlampen im Kfz kann beispielsweise bereits der Schaltausgang von der Elektronik diagnostiziert und dadurch eine Aussage über den Zustand der Last getroffen werden. Durch Kenntnis der Betriebszustände und bzw. oder Messung der bestimmenden elektrischen Größen kann dabei der Ausfall der Lampe detektiert und dem Fahrer oder einem Diagnosesystem gemeldet werden.

Die Genauigkeit des Diagnoseverfahrens wird durch verschiedene Parameter eingeschränkt, wie z.B. Genauigkeit der Messungen und vor allem das verwendete elektrische Modell der Lampen.

Das einfachste Verfahren zur Ermittlung des Lampenzustandes ist eine digitale Entscheidung der Ausgangsspannung im ausgeschalteten Zustand. Bei defekter Lampe ist der Stromkreis unterbrochen, was am Spannungspegel erkannt werden kann.

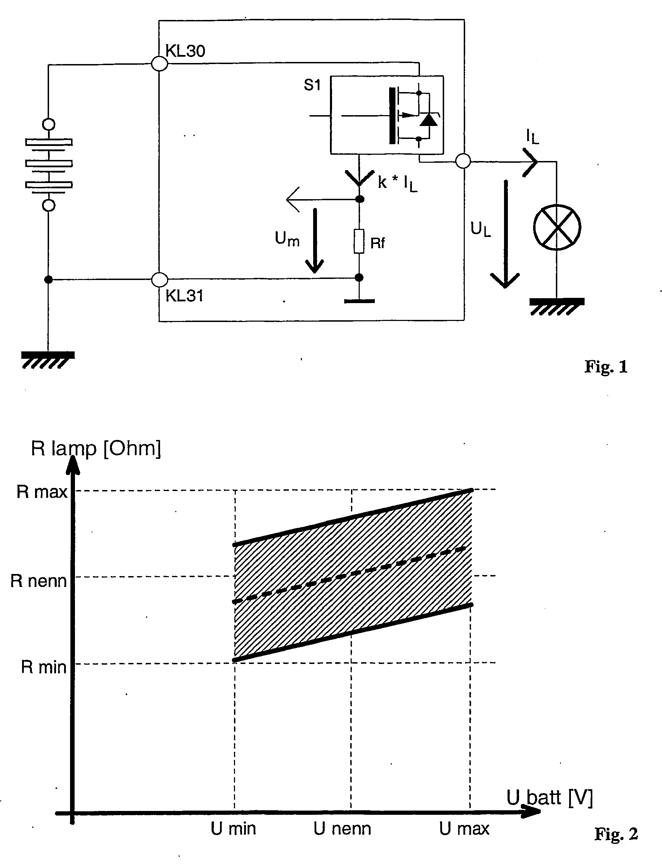

Bessere Verfahren verwenden eine Strommessung im eingeschalteten Zustand der Lampe, wobei ein Messwiderstand oder Stromspiegelschaltungen oder integrierte Lösungen, wie die sogenannten SenseFETs mit einem Steuereingang und einem Stromsignalausgang, wie in Fig. 1 skizziert.

Jedoch kann die Spannung an der Lampenschaltung in einer Vielzahl von Anwendungsfällen, insbesondere in Kraftfahrzeugen nicht als konstant der Nennspannung entsprechend angenommen werden. Weicht die Spannung jedoch von der Nennspannung ab, so entspricht auch die aus dem Produkt von Strom und Spannung aktuelle Leistungsaufnahme nicht der Nennleistung.

Zudem kann der aktuelle Lampenwiderstand schwanken wegen:

- der Verwendung unterschiedlicher Lampentypen
- der unterschiedlichen Nennspannung der verschiedenen Lampentypen
- Abweichungen unterschiedlicher Hersteller
- Streuung innerhalb eines Lampentyps
- Alterung der Lampe

Besonders problematisch ist die Diagnose bei zwei oder mehreren parallel geschalteten Lampen, die wenn überhaupt nur mit Kalibrierung der Elektronik erkannt werden können.

Zudem kann der Einsatz intakter, aber von der Spezifikation abweichender Lampen oder der Defekt einzelner Lampen zu Störungen an der Steuereinheit oder anderen mit der Lampe parallel geschalterer Lampen verursachen.

Aus US-A-5 578 998 ist ein Verfahren zur Funktionsprüfung einer Lampenschaltung, bestehend aus mindestens einer Lampe, bekannt. Die Funktionsprüfung erfolgt durch Messung von Strom und Spannung an einem Widerstand.

Aus EP-A-0 507 186 ein weiteres Verfahren zur Funktionsprüfung einer Lampenschaltung bekannt. Zur Funktionsprüfung werden der Strom und die Spannung an einem Widerstand gemessen.

Aufgabe der Erfindung ist es, ein Verfahren zur Funktionsprüfung einer Lampenschaltung anzugeben, welches auch bei einer von der Nennspannung abweichenden Betriebsspannung eine Funktionsprüfung mit hoher Genauigkeit ermöglicht. Diese Aufgabe wird durch die Merkmale des Anspruchs 1 gelöst. Vorteilhafte Weiterbildungen sind den Unteransprüchen zu entnehmen.

Die Lampenschaltung besteht aus mindestens einer Lampe, d.h. das Verfahren eignet sich insbesondere auch für Lampenschaltungen mit mehreren parallel geschalteten Lampen. Durch Messung von Strom und Spannung erfolgt die Erfassung des aktuellen Betriebszustands. Jede Funktionsprüfung basiert auf einem Vergleich gemessener Werte mit Sollwerten.

Dabei wird für den Widerstandswert ein Polynom zumindest 1. Ordnung gemäß $R = c*U + d$ abhängig von der aktuell gemessenen Spannung an der Lampenschaltung berücksichtigt. Letztlich ist es dabei nicht entscheidend, ob diese Berücksichtigung auf der Seite der Sollwerte oder bei der Umwandlung der gemessenen Werte in abgeleitete Größen erfolgt, also die gemessenen Größen entsprechend auf konstante Sollwerte normiert werden oder die Sollwerte an die Betriebsbedingungen angepasst werden.

Es kann der Widerstandswert der Lampe als Polynom zumindest 1. Ordnung ermittelt werden oder eine weitere Größe abgeleitet werden, wie nachfolgend noch ausführlich erläutert wird.

Die Parameter des Polynoms werden durch eine zumindest der Ordnung des Polynoms entsprechende Anzahl von Messungen bei bekannten sich unterscheidenden Betriebsbedingungen bestimmt

Je höher die Ordnung des Polynoms wird, desto genauer kann die Prognose der Sollwerte bzw. die Annäherung der Messwerte an einen festen Sollwert erfolgen.

Vorzugsweise wird der Widerstandswert auf die Nennleistung bezogen, in dem bei den Messungen bei bekannten Betriebsbedingungen die Parameter des Polynoms des Widerstandswerts jeweils mit der Nennleistung multipliziert werden. Dadurch kann bei Möglichkeit des Einsatzes verschiedener Lampen eine kleinere Schwankungsbreite und bessere Vorgabe erreicht werden.

Weisen die Lampen bei Nennleistung voneinander abweichende Nennspannungen auf, so werden die Parameter des Polynoms auf eine gemeinsame Nennspannung normiert, in dem bei den Messungen bei bekannten Betriebsbedingungen die Parameter des Polynoms des Widerstandswerts jeweils mit dem Verhältnis aus gemeinsamer Nennspannung zu gemittelter Spannung der Lampen bei Nennleistung multipliziert werden. Dadurch kann bei Möglichkeit des Einsatzes verschiedener Lampen eine noch kleinere Schwankungsbreite und bessere Vorgabe erreicht werden.

Vorzugsweise kann als die mit einem Vorgabewert zu vergleichende Größe die Nennleistung der Lampenschaltung ermittelt werden, die aus Strom und Spannung und den aus den Referenzmessungen ermittelten Parametern des Polynoms des Widerstandswerts wird die für die aktuell eingebaute Lampe errechenbare Nennleistung ermittelt und mit dem Sollwert verglichen.

Alternativ kann als Vorgabewert der Sollstrom durch die Lampenschaltung bei der aktuellen Spannung ermittelt werden, d.h. aus der Spannung wird zunächst mittels der Parameter der Widerstandswert für die aktuelle Spannung ermittelt und daraus der für diese Spannung zu erwartende Sollstrom bestimmt und mit dem Iststrom verglichen.

Dabei werden die jeweiligen Normierungen auf Nennleistung und Nennspannung jeweils natürlich berücksichtigt.

Dadurch wird ein Beleuchtungssystem, bestehend aus zumindest einer Lampe und einer Steuereinheit möglich, welche Strom und Spannung erfasst und gemäß dem Verfahren nach einem der vorangehenden Ansprüche den Widerstand der Lampe oder eine daraus abgeleitete Größe ermittelt und mit Vorgabewerten vergleicht und bei Abweichung von den Vorgabewerten erkennt, daß die Lampe defekt ist oder nicht der Vorgabe entspricht.

Dank der verbesserten Annäherung können auch zwei oder mehr parallel geschaltete Lampen gemeinsam überwacht und erkannt werden, daß einer der Lampen defekt ist oder nicht der Vorgabe entspricht. Vorzugsweise wird bei Lampen unterschiedlicher Nennleistung bzw. Widerstand aus dem Maß der Abweichung zu den Vorgabewerten abgeleitet, welche der parallel geschalteten Lampen defekt ist.

Die Erfindung wird nachfolgend anhand von Figuren und Ausführungsbeispielen näher erläutert. Es zeigen:

Fig. 1    bevorzugte Schaltungsanordnung mit SenseFet zur Messung des Stroms in die Lampenschaltung

Fig. 2    Skizze der erreichbaren Verbesserung der Beschreibung des Lampenwiderstands bei Verwendung eines Polynoms erster Ordnung

Fig. 3    Skizze des tatsächlichen Lampenwiderstandsverlaufs für verschiedene Lampen

Fig. 4    Schwankungsbreite bei Verwendung eines Polynoms dritter Ordnung

Fig. 5    Schwankungsbreite bei verschiedenen Lampentypen und Normierung auf die Nennleistung

Fig. 6    Schwankungsbreite bei verschiedenen Lampentypen und Normierung auf die Nennleistung und eine gemeinsame mittlere Nennspannung

Fig. 7    relative Abweichung bei verschiedenen Lampentypen und Normierung auf die Nennleistung und eine gemeinsame mittlere Nennspannung

Fig.8    Parallelschaltung mehrerer Lampen

Die vorliegende Erfindung beschreibt also ein Verfahren zur Funktionsprüfung einer Lampenschaltung, insbesondere zur genauen Bestimmung der Lampennennleistung aus dem gemessenen Lampenstrom bei Betriebsspannung unter Anwendung eines empirisch ermittelten Lampenmodells.

Dabei wird zunächst in Meßreihen bei bekannten sich unterscheidenden Betriebsbedingungen der Arbeitsstrom der Lampe in Abhängigkeit von der Betriebsspannung jeweils für einen Lampentyp gemessen und daraus die Parameter für das Polynom des Widerstand berechnet.

Die Anzahl der Messungen entspricht schon für die Eindeutigkeit der Berechnung der Parameter zumindest der Ordnung des Polynoms, ist jedoch zum Ausgleich von Messschwankungen in der Praxis deutlich höher. Die Parameter werden dann entsprechend gut angenähert, können dann aber für die folgenden Messungen bei von der Nennspannung abweichender Betriebsspannung als konstant angenommen werden.

So kann dann bei einer aktuell gemessenen Spannung ausgehend von diesen konstanten Parametern der Widerstand deutlich genauer bestimmt und somit die Nennleistung exakter angegeben werden.

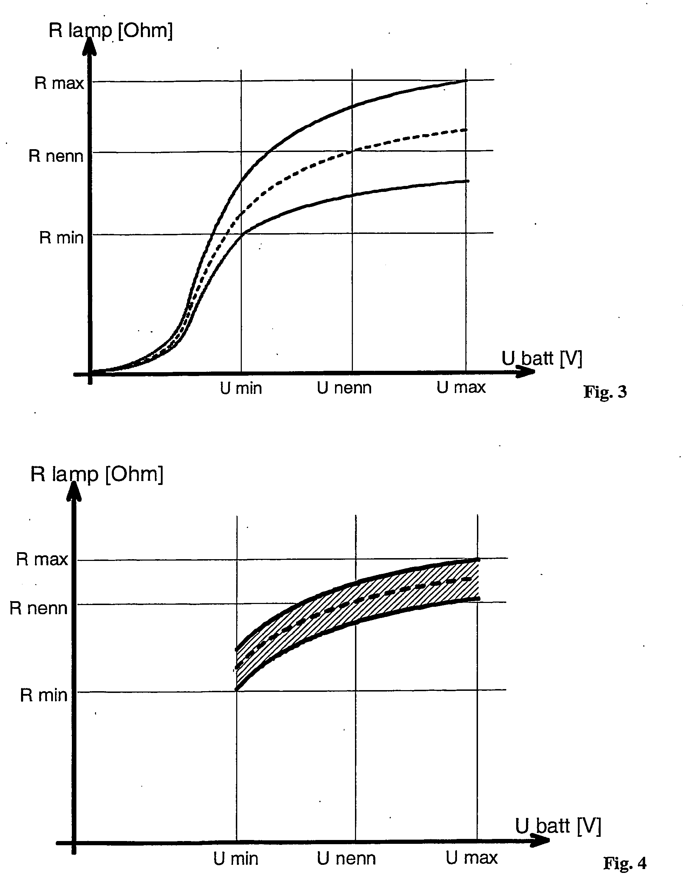

Der Lampenwiderstand über der anliegenden Spannung ist ein Polynom hoher Ordnung und ist in Fig. 3 prinzipiell dargestellt. Für eine Diagnose reicht es aus, den Widerstand der Lampe im Arbeitsspannungsbereich der Lampe ($U_{min}...U_{max}$) zu betrachten. In diesem Bereich kann der Widerstand mit einem Polynom 1. Ordnung grob und mit einem Polynom 3. Ordnung mit sehr guter Genauigkeit angenähert werden. Dabei verdeutlicht Fig. 2, dass ausgehend von einem Nennwiderstand bei Nennspannung und einer definierten Schwankungsbreite (dicke Linien um die gestrichelte Mittellinie) eine feste Vorgabe von Schwellen $R_{max}$.bzw. $R_{min}$ bzw. ein Ansatz des Widerstandswerts als konstant zu derart groben Aussagen führt, dass weder der Einbau einer von der Spezifikation abweichenden Lampe noch der Defekt einer Lampe bei mehreren parallel geschalteten erkannt werden kann.

So ergeben sich für alle bekannten Variablen (verschiedene Lampentypen und Hersteller, Parameterstreuung, Alterung) signifikante Unterschiede, die eine Bestimmung der Lampenleistung, besonders bei Parallelschaltung verschiedener Lampentypen ungenauer werden lassen, wie aus der Schwankungsbreite in Fig. 3 entnommen werden kann, wobei die gestrichelte Linie den mittleren Verlauf die durchgezogenen Linien die Grenzen der tatsächlichen Lampenkennlinien verdeutlichen.

Eine demgegenüber weitergehende entscheidende Verbesserung kann durch Normierung des Widerstandes (bzw. der Parameter) auf die Nennleistung und nochmals besser auf die Nennspannung erzielt werden.

Dabei wird das Polynom des spannungsabhängigen Lampenwiderstandes mit der Nennleistung der Lampe multipliziert:

$$R_{spez} = \frac{U_{lamp}}{I_{lamp}} \cdot P_{nenn} \quad [\Omega \cdot W]; \tag{Gl. 1}$$

Anschließend wird auf eine gemeinsame Nennspannung normiert um die unterschiedlichen Nennspannungen der verschiedenen Lampentypen auszugleichen.

$$R_{spez\_norm} = R_{spez} \cdot \frac{U_{norm}}{U_{nenn\_ist}} = \frac{U_{lamp}}{I_{lamp}} \cdot P_{nenn} \cdot \frac{U_{norm}}{U_{nenn\_ist}} \quad [\Omega \cdot W]; \tag{Gl. 2}$$

wobei $U_{norm}$ die Nennspannung der Lampe zB. 12,0V
und $U_{nenn\_ist}$ die gemittelte Spannung bei Nennleistung eines Lampentyps ist.

Durch diese Normierungen ergibt sich ein nahezu identisches Polynom $R_{spez\_norm}$ für alle Lampentypen, bei dem nur noch ein enges Toleranzband betrachtet werden muß, wie in Fig. 4 skizziert wird.

Durch Umformung von Gl. 3 kann aus dem Polynom die genaue Nennleistung der Lampe in Anhängigkeit von der Betriebsspannung berechnet oder aus einer Tabelle interpoliert werden:

$$P_{nenn} = R_{spez\_norm} \cdot \frac{I_{lamp} \cdot U_{nenn\_ist}}{U_{lamp} \cdot U_{norm}} \; ; \tag{Gl. 3}$$

mit $R_{spez\_norm} = a \cdot U^3 + b \cdot U^2 + c \cdot U + d \; [\Omega \cdot W]$;

Die Bestimmung des Polynoms erfolgt durch Meßreihen, wobei die Ermittlung des spezifischen normierten Widerstandes umso weniger fehlerbehaftet, je weniger verschiedene Lampentypen für die Bestimmung des Polynoms herangezogen werden.

Der Fehler der Interpolationskurven von $R_{spez\_norm}$ zueinander ist dabei kleiner als die Bauteilstreuung innerhalb eines Lampentyps.

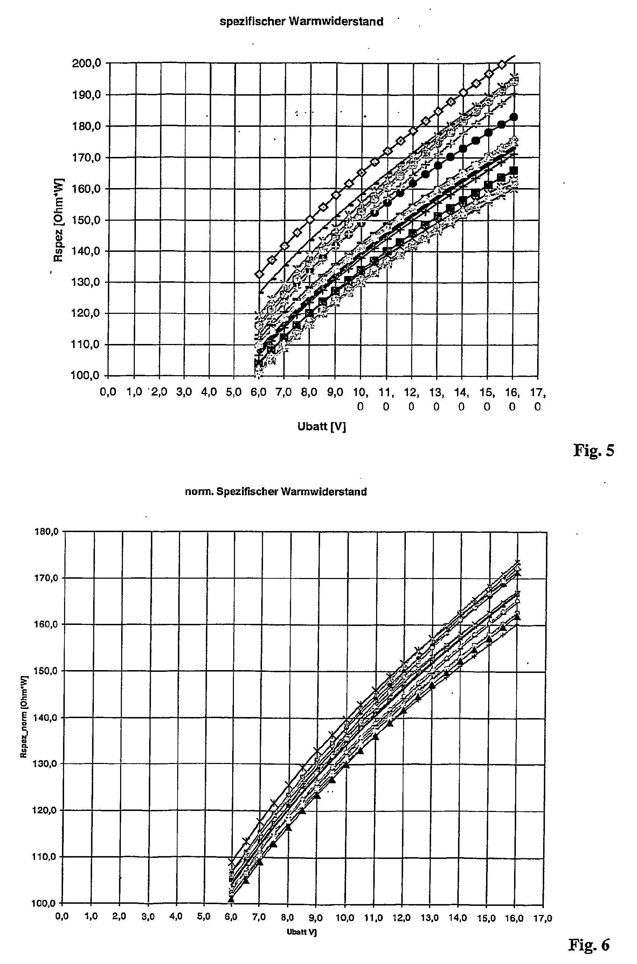

Die Fig. 5 zeigt nun realen Kennlinien für ca. 15 im Kraftfahrzeugbereich übliche Lampen völlig unterschiedlicher Nennleistung (5-60 Watt) die Schwankungsbreite bei Normierung auf die Nennleistung. Bereits optisch ist ganz deutlich erkennbar, daß Lampen mit völlig unterschiedlicher Nennleistung und damit unterschiedlichem Innenwiderstand mit relativ guter Genauigkeit normiert werden können.

Für einige ausgewählte Lampentypen soll dies noch anhand der Tabelle näher erläutert werden. Alle Lampen sind Kfz-Lampen für 12 Volt-Bordnetze.

| Lampentyp | 1 | 2 | 3 | 4 | 5 | Ø bei Nennspg. | Streuung Jabsolut | Streuung relativ |
|---|---|---|---|---|---|---|---|---|
| **Nennleistung [W]** | 60 | 55 | 60 | 7 | 21 | | | |
| **Nennspannung [V]** | 12,25 | 12,6 | 11,85 | 12,8 | 11,75 | | | |
| **Nennstrom [A]** | 4,9 | 4,37 | 5,06 | 0,55 | 1,79 | | | |
| **Rnenn=U/I** | 2,50 | 2,88 | 2,34 | 23,27 | 6,56 | | | |
| **Rspez=R*Pnenn** | 150,00 | 158,58 | 140,51 | 162,91 | 137,85 | **149,97** | 10,93 | 7,29 |
| **d [Ohm] =** | 37 | 39,79 | 37,93 | 42,5 | 36,1 | **38,66** | 2,54 | 6,58 |
| **c [Ohm / V] =** | 13,86 | 14,73 | 13,29 | 13,9 | 13,5 | **13,86** | 0,55 | 3,97 |
| **b [Ohm / V$^2$] =** | -0,5068 | -0,558 | -0,4926 | -0,5 | -0,5075 | **-0,51** | 0,03 | 5,04 |
| **a [Ohm / V$^3$] =** | 0,009 | 0,0103 | 0,0087 | 0,0095 | 0,0097 | **0,01** | 0,00 | 6,60 |

Dabei sind die Nennspannung und der Nennstrom die Größen, die sich bei Vorliegen der Nennleistung einstellen.

Während sich die Nennwiderstände bei den Lampen unterschiedlicher Leistung deutlich unterscheiden (ca. 23 Ohm bei 7 Watt-Lampe gegenüber 2,5 Ohm bei 60 Watt-Lampe), ist der auf die Nennleistung normierte spezifische Widerstandswert recht konstant mit einem Mittelwert von 150 und einer prozentualen Standardabweichung von ca. 7%. d.h. Lampen mit unterschiedlicher Nennleistung können mit verhältnismäßig hoher Genauigkeit durch einen spezifischen Referenzwert bzw. entsprechende Parameter a,b,c,d des Polynoms charakterisiert werden.

Deutlich erkennbar ist in den Beispielen in obiger Tabelle auch, daß die Lampen zum Teil schon von der Sollbordnetzspannung von 12 Volt deutlich abweichende Spannungswerte bei Nennleistung aufweisen. Erkennbar wird auch, daß auch die zwei 60-Watt-Lampentypen noch voneinander abweichende Nennwiderstandswerte aufweisen.

Aus diesem Grund wurde bevorzugt noch eine Normierung auf eine gemeinsame mittlere Nennspannung, hier 12 Volt ergänzt.

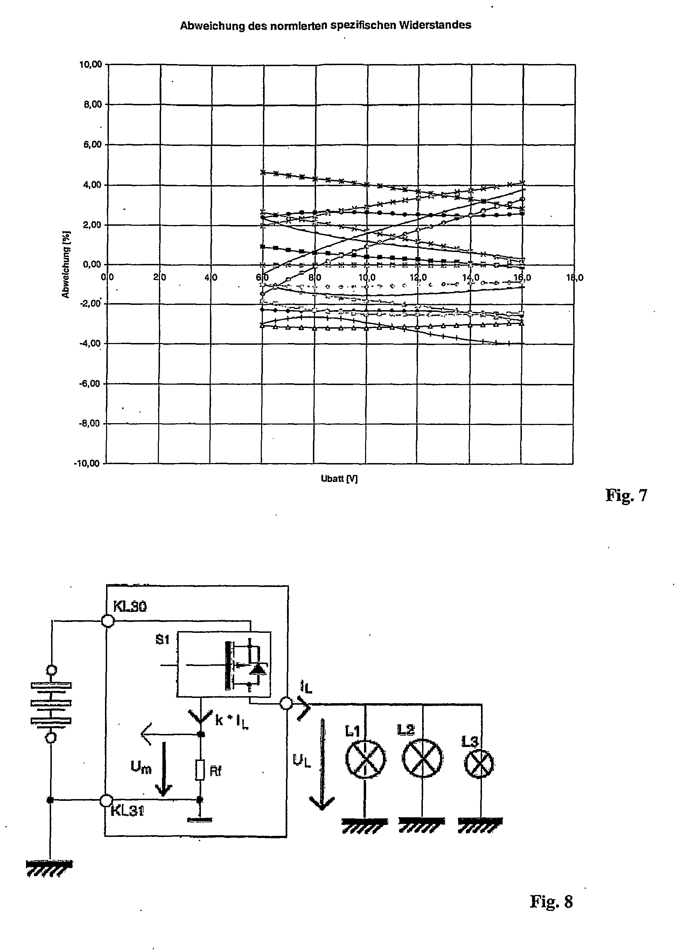

Fig. 6 zeigt die gegenüber Fig. 5 nochmals deutlich reduzierte Schwankungsbreite bei verschiedenen Lampentypen und Fig. 7 zeigt die relative Abweichung bei verschiedenen Lampentypen und Normierung auf die Nennleistung und eine gemeinsame mittlere Nennspannung.

Vorstehend wurde bisher davon ausgegangen, dass die Zuleitungen und deren elektrischer Widerstand gegenüber dem Lampenwiderstand vernachlässigbar waren. Jedoch werden gerade in Kraftfahrzeugen zum Teil Zuleitung von bis zu 6 Metern Länge und dennoch kleinen Querschnitten verlegt, was zu Leitungswiderständen von bis zu >200 Milliohm führt. Kommen nun noch durch Korrosion und unvollständige Kontaktübergänge weitere Leitungswiderstände hinzu, können diese sich auf bis zu 1 Ohm summieren und sind die dabei auftretenden Verluste gegenüber Lampenwiderständen von 3-30 Ohm nicht immer vernachlässigbar.

Daher bietet sich zudem die Möglichkeit, diesen Widerstandswert der Leitung zu erfassen und zu berücksichtigen.

Wenn sich beispielsweise der Widerstand der Glühwendel(n) durch Alterung signifikant ändert, kann dies durch Messung bei verschiedenen Betriebsspannungen erkannt werden.

Da die Messung der Betriebsspannung an der Lampe durch die Elektronik sehr aufwendig wäre, kann die Spannung vereinfacht durch Schätzung der Widerstände im Lastkreis ermittelt werden. Dazu wird die Betriebsspannung am Steuergeräteingang gemessen und die Spannung an der Lampe aus Strom und Widerständen näherungsweise berechnet:

$$U_{lamp} = U_{batt} - I_{lamp} \cdot \left( R_{DSon} + R_{zuleitung} \right) \; ; \qquad (Gl.\ 4),$$

wobei $R_{DSon}$= Einschaltwiderstand des Leistungsschalters
$R_{Zuleitung}$= Widerstand der Lampenzuleitung einschließlich Übergangswiderstand an der Lampenfassung.

Die Genauigkeit der Berechnung der Lampenleistung kann aber auch ohne direktes Ausmessen der Leitung noch weiter erhöht werden, wenn verschiedene Betriebsspannungsmessungen für die Bestimmung der Lampennennleistung herangezogen werden.

Dies beruht auf der Tatsache, daß bei der Berechnung nach Gl.3 die Nennleistung der Lampe konstant sein muß. Weist also eine Lampenschaltung bei zwei aufeinander folgenden Messungen mit unterschiedlichen Spannungen abweichende Nennleistungen auf, ohne dass die Lampe gewechselt wurde, so ist daraus der Einfluß der Zuleitung ableitbar.

Dementsprechend kann für eine spätere Fehleranalyse eine zyklische Erfassung von gemessener Nennleistung und Betriebsspannung erfolgen, wobei die erfassten Werte zumindest bei signifikanten Abweichungen von den Vorwerten abgespeichert und so mehrere Messungen bei unterschiedlichen Betriebszuständen vorliegen und zur Plausibilisierung und Ableitung des Fehlerortes bzw. der Fehlerart zur Verfügung stehen. Vorzugsweise ist zudem ein zeitlicher Bezug, bspw. durch einen Systemzeitzähler mit abgespeichert, so daß bei Änderungen in entsprechend kurzen Zeiträumen dies eindeutig zugeordnet werden kann.

Durch Kalibration der Elektronik bei exakt definierter Last kann der Fehler der Strommessschaltung weiter reduziert und damit die Genauigkeit weiter verbessert werden.

Durch das oben beschriebenen Verfahren kann daher die an den Schaltausgang angeschlossene Nennleistung mit guter Genauigkeit ermittelt werden.

Ein weiterer Vorteil der Erfindung liegt in den umfangreichen Diagnosemöglichkeiten beim Anschluß von zwei oder mehr Lampen an einem Schaltausgang, wo zumindest der Ausfall einer Lampe und vorzugsweise auch noch der Einbau von der Spezifikation nicht entsprechenden Lampen erkannt wird. Dies ermöglicht:

- Einsparung von Kosten und Platzbedarf durch Reduktion der Anzahl der Ausgänge bzw. Schalter, d.h. mit einem Ausgang werden mehrere Lampen gesteuert

- Reduktion der Variantenvielfalt (zB. unterschiedliches Rücklicht/Bremslichtkonzept für USA-Version, Anschluß Sidemarker in USA-Version, Parallelschaltung von Blinkern)

- Erkennung einer möglichen Überlast durch unzulässige Parallelschaltung weiterer Lampen.

Folgende Tabelle zeigt die verschiedenen Diagnosemöglichkeiten verschiedener Konfigurationen:

| Konfiguration | Diagnose | | | | |
|---|---|---|---|---|---|
| | Angeschlossene Nennleistung | Lampentyp | Ausfall einer Lampe | Ausfall von zwei Lampen | Leitungsdaten und -zustand |
| 1 Lampe | ja | 2 Messungen | ja | - | X |
| 2 Lampen mit gleichem Typ | ja | 2 Messungen | ja | ja | X |
| 2 Lampen mit verschiedenem Typ | X | X) | ja | ja | X |
| 3 Lampen mit gleichem Typ | ja | 2 Messungen | ja | ja | X |
| 3 Lampen mit verschiedenem Typ | X | X | ja | ja | X |
| N >3 Lampen mit gleichem Typ | ja | X | ja (für $N \leq 4$) | ja (für $N \leq 6$) | X |
| X= Plausibilität aus 2 Messungen mit unterschiedlicher Betriebsspannung möglich, um Zuleitungseinflüsse zu eliminieren | | | | | |

Die Möglichkeiten der Fehlererkennung bei parallel geschalteten Lampen soll anhand einer Blinkersteuerung gemäß Fig. 8 bestehend aus zwei baugleichen 20 Watt-Lampen vorn und hinten am Kfz sowie einer seitlichen Zusatzleuchte mit 5 Watt gesteuert über einen gemeinsamen Schalter erläutert werden. Die Tabelle zeigt die sich ergebenden Werte bei Nennspannung 12 Volt.

| L1 | L2 | L3 | Gesamt |
|---|---|---|---|
| 20W | 20W | 5W | 45W |
| 1,67 A | 1,67 A | 0,42 A | 3,75 A |
| 7,2 Ω | 7,2 Ω | 28,8 Ω | 3,2 Ohm |

Es ist sofort erkennbar, dass bei einer bisher üblichen sehr groben Schwellendefinition zum Ausgleich von Temperatur- und Spannungsschwankungen ein Ausfall der kleineren 5-Watt-Lampe keinesfalls und selbst der Ausfall oder Einsatz einer abweichenden 20 Watt-Lampe kaum bemerkt werden konnte, berücksichtigt man eine erforderliche Toleranz von 50% ± 3 Ohm.

Dank der deutlich genaueren Bestimmung sind nun die Fälle
L3 defekt = Nennleistung nur noch ca. 40 Watt
L1 oder L2 defekt = Nennleistung noch ca. 25 Watt
L3 und L1 oder L2 defekt = Nennleistung noch ca. 20 Watt voneinander unterscheidbar.

Da die Nennleistung mit einer modellbehafteten Toleranz von ca. 10% angegeben werden kann, können auch die Abweichungen aufgrund von Leitungsstörungen nun erkannt werden.

Das Verfahren kann zudem sowohl bei kontinuierlicher Ansteuerung, als auch im getakteten Betrieb der Lampe verwendet werde. Bei getaktetem Betrieb, also insbesondere bei PWM-Ansteuerung der Lampen, ist die Nennspannung an der Lampe bevorzugt gleich dem Effektivwert des Ausgangssignals

$$U_{lamp} = U_{batt} \cdot \sqrt{dc.} \quad ; \qquad\qquad\qquad\qquad \text{(Gl. 5)}$$

mit dc. = (duty cycle) = Einschaltverhältnis der Pulsweitenmodulation, d.h. es wird vorzugsweise anstelle einer linearen Berechnung $U_{lamp} \approx U_{batt} * T_{ein}/T_{gesamt}$ der quadratische Zusammenhang des Effektivwertes berücksichtigt.

Es sei nochmals hingewiesen, dass dieses Widerstandsmodell für Lampen in gleicher Weise durch Unstellung der Ohmschen Gesetze unmittelbar auch für die Vorgabe von Stromwerten in Abhängigkeit von der aktuellen Spannung anwendbar ist und dann der Vergleich mit dem jeweils gemessenen Strom erfolgt. Alternativ wäre auch der Vergleich der aktuellen Spannung mit einer aus aktuellem Strom und Widerstandsmodell errechneten Sollspannung möglich, wobei der Widerstandswert selbst wiederum von der aktuellen Spannung abhängig ist.

**Patentansprüche**

1. Verfahren zur Funktionsprüfung einer Lampenschaltung, bestehend aus mindestens einer Lampe, durch Messung von Strom und Spannung, **dadurch gekennzeichnet, dass** ein Widerstandswert berücksichtigt wird, welcher als ein Polynom zumindest 1. Ordnung abhängig von der aktuell gemessenen Spannung an der Lampenschaltung vorgegeben wird, wobei die Parameter des Polynoms durch eine zumindest der Ordnung des Polynoms entsprechende Anzahl von Messungen bei bekannten sich unterscheidenden Betriebsbedingungen bestimmt werden und der Widerstandswert oder eine daraus abgeleitete Größe mit einem Vorgabewert verglichen werden.

2. Verfahren nach Anspruch 1, **dadurch gekennzeichnet, dass** ein Polynom zumindest 2. Ordnung gemäß $R = b*U^2 + c*U + d$ verwendet wird.

3. Verfahren nach Anspruch 1, **dadurch gekennzeichnet, dass** ein Polynom zumindest 3. Ordnung gemäß $R = a*U^3 + b*U^2 + c*U + d$ verwendet wird.

4. Verfahren nach Anspruch 1, 2 oder 3, **dadurch gekennzeichnet, dass** der Widerstandswert auf die Nennleistung bezogen wird, in dem bei den Messungen bei bekannten Betriebsbedingungen die Parameter des Polynoms des Widerstandswerts jeweils mit der Nennleistung multipliziert werden.

5. Verfahren nach einem der Ansprüche 1 bis 4, **dadurch gekennzeichnet, dass** die Parameter des Polynoms des Widerstandswerts für eine vorgegebene Menge möglicher einzusetzender Lampen vorgegeben werden, wobei die Lampen bei Nennleistung voneinander abweichende Nennspannungen aufweisen und der Widerstandswert auf eine gemeinsame Nennspannung normiert wird, in dem bei den Messungen bei bekannten Betriebsbedingungen die Parameter des Polynoms des Widerstandswerts jeweils mit dem Verhältnis aus gemeinsamer Nennspannung zu gemittelter Spannung der Lampen bei Nennleistung multipliziert werden.

6. Verfahren nach Anspruch 4, **dadurch gekennzeichnet, dass** als die mit einem Vorgabewert zu vergleichende Größe die Nennleistung der Lampenschaltung ermittelt wird gemäß der Formel:

$$P_{nenn} = R_{spez} \cdot \frac{I_{lamp}}{U_{lamp}}$$

wobei
$I_{lamp}$ der aktuelle Strom durch die Lampenschaltung,
$U_{lamp}$ die aktuelle Spannung über der Lampenschaltung,
$R_{spez}$ der auf die Nennleistung bezogene spezifische Lampenwiderstandswert in $[\Omega*W]$ ist.

7. Verfahren nach Anspruch 5, **dadurch gekennzeichnet, dass** als die mit einem Vorgabewert zu vergleichende Größe die Nennleistung ermittelt wird gemäß der Formel:

$$P_{nenn} = R_{spez\_norm} \cdot \frac{I_{lamp} \cdot U_{nenn\_ist}}{U_{lamp} \cdot U_{norm}} \; ;$$

wobei

$I_{lamp}$ der aktuelle Strom durch die Lampenschaltung,

$U_{lamp}$ die aktuelle Spannung über der Lampenschaltung,

$R_{spez\_norm}$ der auf eine gemeinsame Nennspannung und Nennleistung bezogene, spezifische Lampenwiderstandswert in [$\Omega$*W]

$U_{norm}$ die vereinbarte gemeinsame Nennspannung und

$U_{nenn\_ist}$ die gemittelte Spannung aller Lampen bei Nennleistung ist.

8. Verfahren nach Anspruch 4, **dadurch gekennzeichnet, dass** als Vorgabewert der Sollstrom durch die Lampenschaltung bei der aktuellen Spannung ermittelt wird gemäß der Formel:

$$I_{lamp\_soll} = \frac{P_{nenn} \cdot U_{lamp}}{R_{spez}}$$

9. Verfahren nach Anspruch 5, **dadurch gekennzeichnet, dass** als Vorgabewert der Sollstrom durch die Lampenschaltung bei der aktuellen Spannung ermittelt wird gemäß der Formel:

$$I_{lamp\_soll} = \frac{P_{nenn} \cdot U_{lamp}}{R_{spez\_norm}} \cdot \frac{U_{norm}}{U_{nenn\_ist}}$$

10. Beleuchtungssystem, bestehend aus zumindest einer Lampe (L1, L2, L3) und einer Steuereinheit, welche zur Durchführung des Verfahrens nach einem der vorangehenden Ansprüche 1 bis 9 ausgebildet ist, indem die Steuereinheit Mittel aufweist, um Strom und Spannung zu erfassen und daraus mithilfe ermittelter Parameter des Polynoms den Widerstand der Lampe (L1, L2, L3) oder eine daraus abgeleitete Größe zu ermitteln und mit Vorgabewerten zu vergleichen und bei Abweichung von den Vorgabewerten zu erkennen, daß die Lampe (L1, L2, L3) defekt ist oder nicht der Vorgabe entspricht.

11. Beleuchtungssystem nach Anspruch 10, wobei zumindest zwei Lampen (L1, L2, L3) parallel geschaltet sind, die Steuereinheit Mittel aufweist, um Strom und Spannung zu erfassen und daraus mithilfe ermittelter Parameter des Polynoms den Widerstand der Lampen (L1, L2, L3) oder eine daraus abgeleitete Größe zu ermitteln und mit Vorgabewerten zu vergleichen und bei Abweichung von den Vorgabewerten zu erkennen, daß zumindest einer der Lampen (L 1, L2, L3) defekt ist oder nicht der Vorgabe entspricht.

12. Beleuchtungssystem nach Anspruch 11, wobei Lampen (L1, L2, L3) mit unterschiedlicher Nennleistung parallel geschaltet sind und aus dem Maß der Abweichung zu den Vorgabewerten abgeleitet wird, welche der parallel geschalteten Lampen (L1, L2, L3) defekt ist.

**Claims**

1. Method for functional testing of a lamp circuit, consisting of at least one lamp, by measuring the current and the voltage, **characterized in that** a value of resistance is considered that is predetermined as a polynomial of at least the first order in dependence on the currently measured voltage at the lamp circuit, wherein the parameters of the polynomial are determined under known differing operational conditions by a number of measurements that correspond at least to the order of the polynomial, and the value of resistance or a quantity derived there from are compared with a predetermined value.

2. Method according to claim 1, **characterized in that** a polynomial of at least the second order according to $R = b*U^2$

+ c*U + d is used.

3. Method according to claim 1, **characterized in that** a polynomial of at least the third order according to $R = a*U^3 + b*U^2 + c*U + d$ is used.

4. Method according to claim 1, 2 or 3, **characterized in that** the value of resistance is related to the nominal wattage by multiplying, when the measurements under known operational conditions are carried out, the parameters of the polynomial of the value of resistance by the nominal wattage in each case.

5. Method according to any one of claims 1 to 4, **characterized in that** the parameters of the polynomial of the value of resistance are predetermined for a predetermined set of possible lamps to be used, wherein the nominal voltages of the lamps are different at nominal wattage and the value of resistance is normalized to a common nominal voltage by multiplying, when the measurements under known operational conditions are carried out, the parameters of the polynomial of the value of resistance by the ratio of the common nominal voltage to the mean voltage of the lamps at nominal wattage in each case.

6. Method according to claim 4, **characterized in that** the nominal wattage of the lamp circuit is determined as the quantity to be compared with a predetermined value, according to the following formula:

$$P_{nenn} = R_{spez} \cdot \frac{I_{lamp}}{U_{lamp}}$$

wherein
$I_{lamp}$ is the current currently flowing through the lamp circuit,
$U_{lamp}$ is the current voltage across the lamp circuit,
$R_{spez}$ is the specific value of resistance of the lamp related to the nominal wattage in $[\Omega*W]$.

7. Method according to claim 5, **characterized in that** the nominal wattage is determined as the quantity to be compared with a predetermined value, according to the following formula:

$$P_{nenn} = R_{spez\_norm} \cdot \frac{I_{lamp} \cdot U_{nenn\_ist}}{U_{lamp} \cdot U_{norm}}$$

wherein
$I_{lamp}$ is the current currently flowing through the lamp circuit,
$U_{lamp}$ is the current voltage across the lamp circuit,
$R_{spez\_norm}$ is the specific value of resistance of the lamp related to a common nominal voltage and nominal wattage in $[\Omega*W]$,
$U_{norm}$ is the specified common nominal voltage, and
$U_{nenn\_ist}$ is the mean voltage of all lamps at nominal wattage.

8. Method according to claim 4, **characterized in that** the desired current through the lamp circuit at the current voltage is determined as the predetermined value, according to the following formula:

$$I_{lamp\_soll} = \frac{P_{nenn} \cdot U_{lamp}}{R_{spez}}$$

9. Method according to claim 5, **characterized in that** the desired current through the lamp circuit at the current voltage is determined as the predetermined value, according to the following formula:

$$I_{lamp\_soll} = \frac{P_{nenn} \cdot U_{lamp}}{R_{spez\_norm}} \cdot \frac{U_{norm}}{U_{nenn\_ist}}$$

10. Lighting system consisting of at least one lamp (L1, L2, L3) and a control unit, said control unit being formed for carrying out the method according to any one of the preceding claims 1 to 9 in that the control unit has means for detecting the current and the voltage and for determining there from, by means of determined parameters of the polynomial, the resistance of the lamp (L1, L2, L3) or a quantity derived there from and for comparing them with predetermined values, and for recognizing, if there is a deviation from the predetermined values, that the lamp (L1, L2, L3) is defective or does not perform according to the predetermined values.

11. Lighting system according to claim 10, wherein at least two lamps (L1, L2, L3) are connected in parallel, the control unit has means for detecting the current and the voltage and for determining there from, by means of determined parameters of the polynomial, the resistance of the lamps (L1, L2, L3) or a quantity derived there from and for comparing them with predetermined values, and for recognizing, if there is a deviation from the predetermined values, that at least one of the lamps (L1, L2, L3) is defective or does not perform according to the predetermined values.

12. Lighting system according to claim 11, wherein lamps (L1, L2, L3) of different nominal wattages are connected in parallel and it is derived from the extent of deviation from the predetermined values which of the lamps (L1, L2, L3) that are connected in parallel is defective.

**Revendications**

1. Procédé de contrôle de fonctionnement d'un circuit de lampe, composé d'au moins une lampe, par la mesure de l'intensité et de la tension, **caractérisé en ce qu'**une valeur de résistance est prise en considération, qui est prédéfinie en tant que polynôme au moins de 1er ordre en fonction de la tension mesurée actuellement sur le circuit de lampe, les paramètres du polynôme étant définis par un nombre de mesures correspondant au moins à l'ordre du polynôme, en présence de conditions de fonctionnement connues qui diffèrent, et la valeur de résistance ou une grandeur qui en est dérivée étant comparée à une valeur prédéfinie.

2. Procédé selon la revendication 1, **caractérisé en ce qu'**un polynôme au moins de 2ème ordre selon $R = b*U^2 + c*U + d$ est utilisé.

3. Procédé selon la revendication 1, **caractérisé en ce qu'**un polynôme au moins de 3ème ordre selon $R = a*U^3 + b*U^2 + c*U + d$ est utilisé.

4. Procédé selon la revendication 1, 2 ou 3, **caractérisé en ce que** la valeur de résistance est rapportée à la puissance nominale par le fait que, lors des mesures en présence de conditions de fonctionnement connues, les paramètres du polynôme de la valeur de résistance sont à chaque fois multipliés par la puissance nominale.

5. Procédé selon une des revendications 1 à 4, **caractérisé en ce que** les paramètres du polynôme de la valeur de résistance sont prédéfinis pour un nombre prédéfini de lampes à utiliser possibles, les lampes présentant à la puissance nominale des tensions nominales qui diffèrent les unes des autres, et la valeur de résistance étant normalisée à une tension nominale commune par le fait que, lors des mesures en présence de conditions de fonctionnement connues, les paramètres du polynôme de la valeur de résistance sont multipliés à chaque fois par le rapport de la tension nominale commune à la moyenne de la tension des lampes à la puissance nominale.

6. Procédé selon la revendication 4, **caractérisé en ce que,** en tant que grandeur à comparer à une valeur prédéfinie, la puissance nominale du circuit de lampe est déterminée selon la formule :

$$P_{nom} = R_{sp\acute{e}c} \cdot \frac{Ilamp}{Ulamp}$$

$I_{lamp}$ étant l'intensité actuelle traversant le circuit de lampe,
$U_{lamp}$ étant la tension actuelle sur le circuit de lampe,
$R_{sp\acute{e}c}$ étant la valeur de résistance de lampe spécifique, en [$\Omega$*W], rapportée à la puissance nominale.

7. Procédé selon la revendication 5, **caractérisé en ce que,** en tant que grandeur à comparer à une valeur prédéfinie, la puissance nominale est déterminée selon la formule :

$$P_{nom} = R_{sp\acute{e}c\_norm} \cdot \frac{Ilamp.Unom\_eff}{Ulamp.Unorm}$$

$I_{lamp}$ étant l'intensité actuelle traversant le circuit de lampe,
$U_{lamp}$ étant la tension actuelle sur le circuit de lampe,
$R_{sp\acute{e}c\_norm}$ étant la valeur de résistance de lampe spécifique, en [$\Omega$*W], rapportée à une tension nominale et une puissance nominale communes,
$U_{norm}$ étant la tension nominale commune convenue et
$U_{nom\_eff}$ étant la moyenne de la tension de toutes les lampes à la puissance nominale.

8. Procédé selon la revendication 4, **caractérisé en ce que,** en tant que valeur prédéfinie, l'intensité de consigne traversant le circuit de lampe pour la tension actuelle est déterminée selon la formule :

$$Ilamp\_cons. = \frac{Pnom.Ulamp}{Rsp\acute{e}c}$$

9. Procédé selon la revendication 5, **caractérisé en ce que,** en tant que valeur prédéfinie, l'intensité de consigne traversant le circuit de lampe pour la tension actuelle est déterminée selon la formule :

$$Ilamp\_cons. = \frac{Pnom.Ulamp}{Rsp\acute{e}c\_norm} \cdot \frac{Unorm}{Unom\_eff}$$

10. Système d'éclairage, composé d'au moins une lampe (L1, L2, L3) et d'une unité de commande qui est constituée pour l'exécution du procédé selon une des revendications précédentes 1 à 9, par le fait que l'unité de commande présente des moyens pour détecter l'intensité et la tension et pour, à partir de là et à l'aide de paramètres déterminés du polynôme, déterminer la résistance de la lampe (L1, L2, L3) ou une grandeur qui en est dérivée, et la comparer à des valeurs prédéfinies et, en cas d'écart aux valeurs prédéfinies, pour détecter que la lampe (L1, L2, L3) est défectueuse ou ne correspond pas à la valeur prédéfinie.

11. Système d'éclairage selon la revendication 10, au moins deux lampes (L1, L2, L3) étant montées en parallèle, l'unité de commande présentant des moyens pour détecter l'intensité et la tension et pour, à partir de là et à l'aide de paramètres déterminés du polynôme, déterminer la résistance des lampes (L1, L2, L3) ou une grandeur qui en est dérivée, et la comparer à des valeurs prédéfinies et, en cas d'écart aux valeurs prédéfinies, pour détecter qu'au moins une des lampes (L1, L2, L3) est défectueuse ou ne correspond pas à la valeur prédéfinie.

12. Système d'éclairage selon la revendication 11, des lampes (L1, L2, L3) de puissances nominales différentes étant montées en parallèle et, à partir de la dimension de l'écart aux valeurs prédéfinies, étant défini laquelle des lampes (L1, L2, L3) montées en parallèle est défectueuse.

Fig. 1

Fig. 2

Fig. 3

Fig. 4

spezifischer Warmwiderstand

**Fig. 5**

norm. Spezifischer Warmwiderstand

**Fig. 6**

Abweichung des normierten spezifischen Widerstandes

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5578998 A

- EP 0507186 A